Europäisches Patentamt

European Patent Office

Office européen des brevets

(11) Veröffentlichungsnummer: **0 045 445**
**A1**

(12) **EUROPÄISCHE PATENTANMELDUNG**

(21) Anmeldenummer: **81105800.7**

(22) Anmeldetag: **22.07.81**

(51) Int. Cl.³: **H 01 L 21/302**
**C 23 F 1/04**

(30) Priorität: **06.08.80 DE 3029828**

(43) Veröffentlichungstag der Anmeldung:
**10.02.82 Patentblatt 82/6**

(84) Benannte Vertragsstaaten:
**CH DE FR GB IT LI**

(71) Anmelder: **SIEMENS AKTIENGESELLSCHAFT Berlin und München**
**Postfach 22 02 61**
**D-8000 München 22(DE)**

(72) Erfinder: **Kolbesen, Bernd, Dr.**
**Leopoldstrasse 136**
**D-8000 München 40(DE)**

(54) Verfahren zum Zerteilen eines Halbleitereinkristalls in Scheiben.

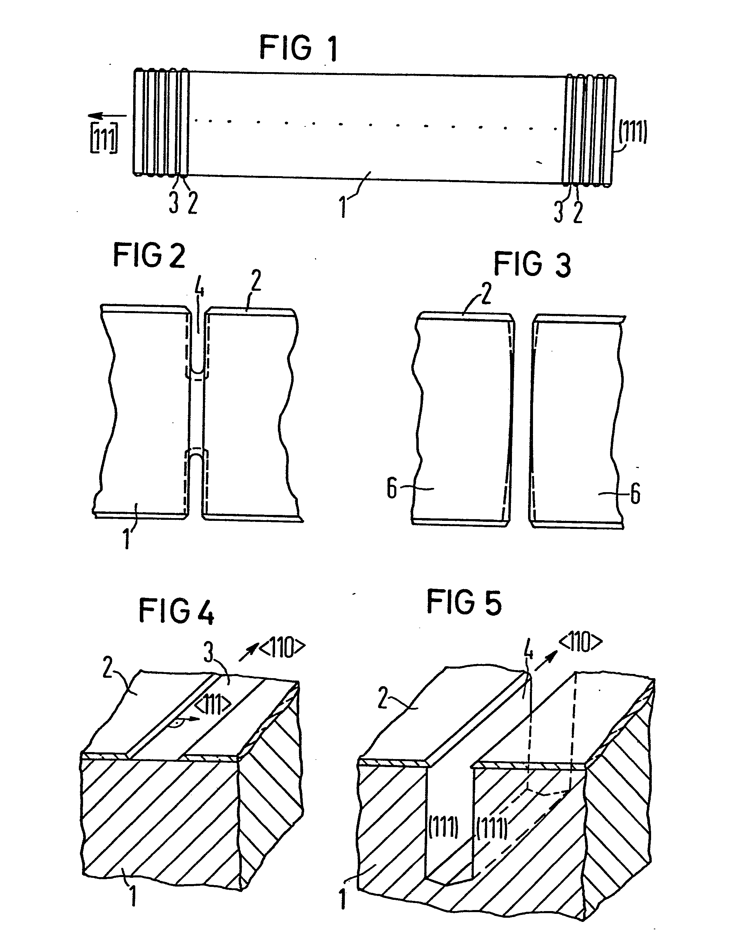

㊷ Die Erfindung betrifft ein Verfahren zum Zerteilen eines im wesentlichen stabförmigen Halbleitereinkristalls in Scheiben, bei dem der Halbleitereinkristall selektiv mit einem anisotropen Ätzmittel geätzt wird (Fig. 1).

FIG 1

EP 0 045 445 A1

SIEMENS AKTIENGESELLSCHAFT
Berlin und München

Unser Zeichen:
VPA
80 P 1 1 2 1 E

## Verfahren zum Zerteilen eines Halbleitereinkristalls in Scheiben

Die Erfindung betrifft ein Verfahren zum Zerteilen eines im wesentlichen stabförmigen Halbleitereinkristalls in Scheiben.

Halbleiterbauelemente werden in der Regel aus Halbleiterscheiben hergestellt, die von meist stabförmigen Einkristallen abgetrennt werden. Zum Abtrennen der Scheiben werden mechanische Sägeverfahren, die hauptsächlich nach dem Innenlochsägeprinzip arbeiten, verwendet. Eine entsprechende Innenlochsäge ist beispielsweise aus der DE-AS 22 04 491 bekannt. Diese Sägeverfahren haben den Nachteil, daß der Verlust an Halbleitermaterial, bezogen auf die Scheibendicke, 50 bis 100 % beträgt.

Zum Behandeln von Halbleiterscheiben, z.B. zum Reinigen der Scheibenoberfläche, sind zahlreiche Ätzverfahren bekannt. Im "Annual Review of Materials Science" Ed. R.A. Huggins, Vol. 9: 373 - 403 (1979), Palo Alto CA. Ann. Rev. Inc., ist beschrieben, daß sich in $[110]$ - orientierte Siliciumscheiben Schlitze, die von (111)- Netzebenen begrenzt sind, ätzen lassen, wenn man auf der Scheibenoberfläche eine geeignete Maskierschicht, die vom Ätzmittel nicht oder sehr viel langsamer als Silicium angegeriffen wird, vorsieht und die Maskierschicht durch eine Art von Fototechnik beispielsweise streifenförmig strukturiert und als Ätzmittel ein anisotropes Ätzmittel, nämlich Kaliumhydroxid (KOH) verwendet. Anisotrope Ätzmittel unterscheiden sich von isotropen Ätzmitteln dadurch, daß sie verschiedene Netzebenen eines Kristallgitters, beispielsweise eines

4.8.80
Nte 1 Si

0045445
80 P 1121 E

Siliciumkristallgitters, mit unterschiedlicher Ätz- geschwindigkeit angreifen. Besonders große Ätzraten- unterschiede weist für Silicium als Halbleitermaterial 44-prozentige wässrige KOH auf, da sich bei KOH die Ätzgeschwindigkeiten der Netzebenen (110)/(100)/(111) wie 600 : 300 : 1 verhalten.

Die Erfindung macht sich diese Erkenntnis zunutze und löst die gestellte Aufgabe, nämlich die Zerteilung eines im wesentlichen stabförmigen Halbleitereinkristalls in Scheiben bei geringem Abfallanfall dadurch, daß der Halbleitereinkristall selektiv mit einem anisotropen Ätzmittel geätzt wird. Dadurch wird es ermöglicht, den zum Zerteilen notwendigen technischen Aufwand und die bei der Zerteilung anfallende Abfallmenge an Halbleitermaterial erheblich zu verringern.

Es liegt im Rahmen der Erfindung, daß ein in [111]- Richtung orientiert gezogener Halbleitereinkristallstab mit einem anisotropen Ätzmittel selektiv geätzt wird, das bezüglich der (110)- und (100)-Netzebenen um mindestens eine Größenordnung größere Ätzraten aufweist als bezüglich der (111)-Ebene, daß ein in [110]-Richtung orientiert gezogener Halbleitereinkristallstab mit einem anisotropen Ätzmittel selektiv geätzt wird, das bezüglich der (110)- und (100)-Netzebenen um mindestens eine Größenordnung größere Ätzraten aufweist als bezüglich der (111)- Ebene, daß der Halbleitereinkristallstab zur selektiven Ätzung mit einer Maskierungsschicht versehen wird, die in bestimmten Abständen auf dem Kristallstabmantel streifenförmig unterbrochen wird und daß die streifenförmigen Unterbrechungen so ausgerichtet werden, daß sie parallel zu den Schnittlinien der (111)-Ebenen mit der Stabmanteloberfläche liegen.

Die Maskierschicht kann beispielsweise mittels eines folithografischen Prozesses, mittels Ritzen oder mittels Laserbestrahlung streifenförmig unterbrochen werden, so daß nur an den Stellen, an denen die Maskierschicht am Kristallstabmantel entfernt bzw. beschädigt ist, das Ätzmittel den Halbleiterstab angreifen kann.

Es ist von Vorteil, daß die Maskierschicht durch 2 bis 200 $\mu$m, insbesondere 10 bis 50 $\mu$m breite Streifen unterbrochen wird und daß die Maskierschicht in Abständen von mindestens 200 $\mu$m streifenförmig unterbrochen wird.

Es liegt im Rahmen der Erfindung, daß als Mittel zum anisotropen Ätzen eine wässrige Kaliumhydroxydlösung oder eine wässrige Lösung aus einem Brenzkatechin/Äthylendiamingemisch verwendet wird und daß als zu ätzender Halbleiterstab ein Siliciumstab verwendet wird.

Zur Maskierung kann vorteilhafterweise ein Mittel, das um den Faktor $10^4$ bis $10^6$ langsamer vom Ätzmittel angegriffen wird als das zu ätzende Halbleitermaterial, beispielsweise eine Metallschicht aus Reinsteisen, -Chrom, -Nickel, Nickelchrom usw. oder eine Schicht aus $Al_2O_3$, $SiO_2$, $Si_3N_4$ oder Kombinationen davon verwendet werden.

In einer Weiterbildung des Verfahrens ist vorgesehen, daß zur Erhöhung der Ätzrate das Ätzmittel während des Ätzvorganges insbesondere durch einen Rührvorgang, durch Drehen des Halbleiterstabes , durch Ultraschall, bewegt wird oder durch Erwärmung auf eine geeignete Temperatur gebracht wird.

Es ist aber auch möglich, zur Erhöhung der Ätzrate auf die durchzuätzenden Stellen des Halbleiterkristalls einen mechanischen Druck, insbesondere durch Hin- und Herbewegung mindestens eines Metalldrahtes oder Metallblattes, auszuüben.

-4-

Die Erfindung wird im folgenden anhand der als Ausführungsbeispiel zu wertenden Figuren 1 bis 5 näher erläutert. Die Figur 1 zeigt einen mit einer Maskierschicht, die von ringförmigen Streifen unterbrochen wird, versehenen Halbleitereinkristallstab. Die Figuren 2 und 3 zeigen ausschnittsweise den Einkristallstab in unterschiedlichen Verfahrensabschnitten in Draufsicht, während die Figuren 4 und 5 das erfindungsgemäße Verfahren anhand eines vergrößert dargestellen Ausschnittes der Staboberfläche verdeutlichen.

Die Figur 1 zeigt einen rundgeschliffenen, $\left[111\right]$-orientiert gezogenen Silicium-Einkristallstab 1, der mit einer aus Gründen der Einfachheit nur teilweise dargestellten Maskierschicht 2 bedeckt wurde und bei dem die Maskierschicht 2 in äquidistanten Abständen in Form von ringförmigen Streifen 3 entfernt wurde. Die ringförmigen Streifen werden so ausgerichtet, daß sie parallel zu den Schnittlinien der (111)-Ebenen mit der Stabmanteloberfläche liegen. Die Streifen 3 können durch ein fototechnisches Verfahren mit anschließender Ätzung, durch Ritzen mit Diamant, durch Laserbestrahlung oder eine andere Technik erzeugt werden. Es genügt, die Maskierschicht so zu beschädigen, daß das Ätzmittel später an diesen Stellen das Silicium angreifen kann.

Einen vergrößerten Ausschnitt aus der Stabmanteloberfläche nach der Durchführung eines fotolithografischen Prozesses zeigt Figur 4.

Der mit ringförmigen Streifen 3 versehene Siliciumeinkristallstab 1 wird anschließend in ein mit einem anisotropen Ätzmittel, das insbesondere in Richtung der (111)-Netzebene eine im Vergleich zu anderen Netzebenen geringe Ätzrate aufweist, gefülltes Bad eingebracht. Es entstehen aufgrund der in den $\left\{110\right\}$-Netzebenen erheblich höheren Ätzgeschwindigkeit zunächst im Stab ringförmige Rillen 4, die seitlich von (111)-Ebenen begrenzt sind.

BAD ORIGINAL

Dieser Verfahrenszustand ist in Figur 2, die einen Stabausschnitt in Draufsicht und in Figur 5, die einen Ausschnitt aus der Staboberfläche darstellt, gezeigt. Der
Ätzangriff schreitet aufgrund der Anisotropie des Ätzmittels hauptsächlich in die Tiefe und nur sehr wenig
zur Seite fort. Schließlich zerfällt der Stab, wie in
Figur 3 ausschnittsweise gezeigt, in einzelne Scheiben
6.

Der Vorteil der Erfindung gegenüber den gebräuchlichen
Sägeverfahren zur Halbleiterscheibenherstellung liegt
darin, daß nicht Scheibe um Scheibe einzeln, sondern
alle Scheiben aus einem Stab gleichzeitig abgetrennt
werden. Dabei können je nach Größe des Ätzbades mehrere
Halbleiterstäbe auf einmal in Scheiben trenngeätzt werden.
Der Siliciumverlust beim Trennätzen ist mindestens um
50 % geringer als bei herkömmlichen mechanischen Sägeverfahren.

Vorteilhafterweise wird als anisotropes Ätzmittel KOH, z.B.
eine 44-prozentige wässrige KOH benutzt. Es können aber
auch andere anisotrope Ätzsysteme, z.B. Brenzkatechin/
Äthylendiamin/$H_2O$ zur Anwendung kommen.

Die maskierende Schicht 2 sollte vom Ätzmittel um den
Faktor $10^4$ bis $10^6$ langsamer angegriffen werden als das
zuätzende Halbleitermaterial. Bei einem Faktor von $10^5$
würde beispielsweise eine Maskierschichtdicke von 1 $\mu$m
notwendig sein, um $10^5$ $\mu$m, d.h. 10 cm tief zu ätzen.

Als Maskierschicht gegenüber wässriger KOH können Metalle,
z.B. Reinsteisen, Oxide, z.B. $Al_2O_3$, oder Kombinationen
solcher Schichten verwendet werden. Die Maskierschicht
kann durch Aufdampfen, Kathodenzerstäubung, Galvanik oder
ähnliche Verfahren aufgebracht werden.

Nach den erfindungsgemäßen Verfahren können außer Silicium,
dem häufigsten Anwendungsfall, auch andere einkristalline
Halbleiter, wie beispielsweise Germanium oder III-V-
Verbindungen behandelt werden. Ferner kann das erfindungsgemäße Verfahren nicht nur auf [111]-orientiert gezogene
Halbleiterstäbe, sondern auch auf [110]-gezogene Halbleiterstäbe mit Vorteil angewandt werden. Werden bei [110]-
orientierten Stäben die die Maskierschicht unterbrechenden
Streifen nicht ringförmig am Kristallstabmantel, sondern
in Richtung Stabachse am Kristallstabmantel so angeordnet,
daß sie parallel zu den Schnittlinien der (111)-Ebenen
mit der Stabmanteloberfläche liegen, so zerfällt der
Halbleiterstab nicht in ringförmige, sondern in bretterförmige Scheiben bzw. Platten, deren Länge im wesentlichen
mit der Länge des Halbleiterstabes identisch ist. Entsprechende, insbesondere aus Silicium-Einkristallstäben
hergestellte Bretter können mit Vorteil zu Solarzellen
weiterverarbeitet werden, bzw. als Ausgangsmaterial für
großflächige Solarzellen dienen.

Die Breite der streifenförmigen Unterbrechungen 3 der
Maskierschicht 2 sollte im Bereich zwischen 2 µm und
200 µm gewählt werden, da sonst einerseits die Ätzgeschwindigkeit zu gering und andererseits der Verschnittanfall zu groß wäre. Vorteilhaft ist eine Breite der
Streifen 3 im Bereich von 10 bis 50 µm. Der Abstand
zwischen den einzelnen Streifen 3 sollte für selbsttragende Siliciumscheiben mindestens 200 µm betragen und
hängt im übrigen von der Verwendung der abgetrennten
Scheiben ab.

Beispiel:

Ein [111]-orientierter Silicium-Einkristallstab mit
100 mm Durchmesser wird zunächst - u.a. um einen gleichmäßigen Maskierungsüberzug zu erreichen - rundgeschliffen.
Anschließend wird eine ca. 1 µm dicke Maskierschicht 2
aus Reinsteisen angebracht. Dann wird die Maskierschicht 2 mittels eines fotolithografischen Prozesses in ca. 20 $\mu$m breiten ringförmigen Streifen 3, die in Abständen von etwa 400 $\mu$m auf dem Kristallstabmantel so angeordnet sind, daß sie parallel zur Schnittlinie der (111)-Ebenen mit der Stabmanteloberfläche liegen, entfernt. Anschließend erfolgt die anisotrope Ätzung mit 44-prozentiger wässriger KOH. Das Trennen der Scheiben dauert bei 100 $^{\circ}$C Ätmittel-temperatur ohne Bewegung des Ätzmittels etwa 7 Tage. Die seitliche Unterätzung beträgt dann ca. 80 $\mu$m, d.h. je 40 $\mu$m zur Seite. Bei einer ursprünglichen Streifenbreite von 20 $\mu$m beträgt somit der Siliciumverlust ca. 100 $\mu$m.. Dies entspricht bei einer ursprünglichen Scheibendicke von 400 $\mu$m 25 % Verlust an Silicium durch die Trennätzung. Bei herkömmlichen Sägeverfahren beträgt dagegen der Sägeverlust 50 bis 100 %, bezogen auf die Scheibendicke. Gleiche Ergebnisse werden erreicht, wenn $Al_2O_3$ als Maskier-schicht verwendet wird und die Maskierschicht durch Ritzen mit einem Diamanten streifenförmig unterbrochen wird.

Als Nachteil könnte angesehen werden, daß die Ätzraten entsprechender Ätzmittel relativ gering sind, die Ätzdauer daher in der Größenordnung von Tagen liegt. Für 44-prozentige wässrige KOH, Siedepunkt ca. 120 $^{\circ}$C, gilt für (110)-Kristallebenen:

| Temp. $[^{\circ}C]$ | Ätzrate $[\mu m/min]$ | Ätzzeit für 50 mm tiefe Rillen $[Minuten]$ | $[Tage]$ |
|---|---|---|---|
| 40 | 0,13 | $3,8 \cdot 10^5$ | 270 |
| 80 | 1,5 | $3,5 \cdot 10^4$ | 23,5 |
| 100 | 5,0 | $10^4$ | 7 |
| 120 | 11,5 | $4,35 \cdot 10^3$ | 3 |

Es ist jedoch möglich, die Ätzraten durch verschiedene Verfahren zu erhöhen. Die Ätzrate kann z.B. durch Wahl der geeigneten Temperatur oder durch Bewegung des Ätzmittels erhöht werden.

Eine solche Bewegung kann durch im Ätzbad angeordnete
Rührvorrichtungen, durch Drehen des Halbleiterkristalles,
durch Ultraschall oder andere Verfahren erreicht werden.

Eine andere Möglichkeit der Ätzratenerhöhung besteht in
einer Kombination der anisotropen Ätzung mit mechanischer
Einwirkung auf die Stellen des Halbleiter-Kristalls, an
denen das Ätzmittel angreift. Bei einer entsprechenden
"chemischen Säge" kann z.B. ein Draht oder ein Metallblatt in einer Hin- und Herbewegung gegen das Halbleitermaterial gedrückt werden, wobei der Halbleiterstab vorteilhafterweise um seine Längsachse gedreht wird. Es ist
auch möglich, entsprechend der Anzahl der Streifen 3 bzw.
der Anzahl der zu erzeugenden Halbleiterscheiben eine
Vielzahl von Drähten oder Blättern entsprechend dem Prinzip einer Gattersäge parallel zueinander anzuordnen.

5 Figuren
23 Patentansprüche

Patentansprüche

1. Verfahren zum Zerteilen eines im wesentlichen stabförmigen Halbleitereinkristalls in Scheiben, d a d u r c h g ek e n n z e i c h n e t, daß der Halbleitereinkristall selektiv mit einem anisotropen Ätzmittel geätzt wird.

2. Verfahren nach Anspruch 1, d a d u r c h g e k e n n z e i c h n e t, daß ein in $[\bar{1}11]$-Richtung orientiert gezogener Halbleitereinkristallstab mit einem anisotropen Ätzmittel selektiv geätzt wird, das bezüglich der (110)- und (100)-Netzebenen um mindestens eine Größenordnung größere Ätzraten aufweist als bezüglich der (111)-Ebene.

3. Verfahren nach Anspruch 1, d a d u r c h g e k e n n z e i c h n e t, daß ein in $[\bar{1}10]$-Richtung orientiert gezogener Halbleitereinkristallstab mit einem anisotropen Ätzmittel selektiv geätzt wird, das bezüglich der (110)- und (100)-Netzebenen um mindestens eine Größenordnung größere Ätzraten aufweist als bezüglich der (111)-Ebene.

4. Verfahren nach wenigstens einem der Ansprüche 1 bis 3, d a d u r c h g e k e n n z e i c h n e t, daß der Halbleitereinkristallstab zur selektiven Ätzung mit einer Maskierungsschicht versehen wird, die in bestimmten Abständen auf dem Kristallstabmantel streifenförmig unterbrochen wird.

5. Verfahren nach wenigstens einem der Ansprüche 1 bis 4, d a d u r c h g e k e n n z e i c h n e t, daß die streifenförmigen Unterbrechungen so ausgerichtet werden, daß sie parallel zu den Schnittlinien der (111)-Ebenen mit der Stabmanteloberfläche liegen.

6. Verfahren nach wenigstens einem der Ansprüche 1 bis 5, d a d u r c h g e k e n n z e i c h n e t , daß die Maskierschicht mittels eines fotolithographischen Prozesses streifenförmig unterbrochen wird.

7. Verfahren nach wenigstens einem der Ansprüche 1 bis 6, d a d u r c h g e k e n n z e i c h n e t , daß die Maskierschicht mittels Ritzens streifenförmig unterbrochen wird.

8. Verfahren nach wenigstens einem der Ansprüche 1 bis 7, d a d u r c h g e k e n n z e i c h n e t , daß die Maskierschicht mittels Laserbestrahlung streifenförmig unterbrochen wird.

9. Verfahren nach wenigstens einem der Ansprüche 1 bis 8, d a d u r c h g e k e n n z e i c h n e t , daß die Maskierschicht durch 2 bis 200 $\mu$m, insbesondere 10 bis 50 $\mu$m breite Streifen unterbrochen wird.

10. Verfahren nach wenigstens einem der Ansprüche 1 bis 9, d a d u r c h g e k e n n z e i c h n e t , daß die Maskierschicht in Abständen von mindestens 200 $\mu$m streifenförmig unterbrochen wird.

11. Verfahren nach wenigstens einem der Ansprüche 1 bis 10, d a d u r c h g e k e n n z e i c h n e t , daß als Mittel zum anisotropen Ätzen eine wässrige Kaliumhydroxydlösung verwendet wird.

12. Verfahren nach wenigstens einem der Ansprüche 1 bis 10, d a d u r c h g e k e n n z e i c h n e t , daß als Mittel zum anisotropen Ätzen eine wässrige Lösung aus Brenzkatechin und Äthylendiamin verwendet wird.

13. Verfahren nach wenigstens einem der Ansprüche 1 bis 12, d a d u r c h   g e k e n n z e i c h n e t, daß als zu ätzender Halbleiterstab ein Siliciumstab verwendet wird.

14. Verfahren nach wenigstens einem der Ansprüche 1 bis 13, d a d u r c h   g e k e n n z e i c h n e t, daß zur Maskierung ein Mittel, das um den Faktor $10^4$ bis $10^6$ langsamer vom Ätzmittel angegriffen wird als das zu ätzende Halbleitermaterial, verwendet wird.

15. Verfahren nach wenigstens einem der Ansprüche 1 bis 14, d a d u r c h   g e k e n n z e i c h n e t, daß zur Maskierung Reinstchrom, Reinsteisen, $Al_2O_3$, $SiO_2$ oder $Si_3N_4$ verwendet wird.

16. Verfahren nach wenigstens einem der Ansprüche 1 bis 15, d a d u r c h   g e k e n n z e i c h n e t, daß das Ätzmittel während des Ätzvorgangs bewegt wird.

17. Verfahren nach wenigstens einem der Ansprüche 1 bis 16, d a d u r c h   g e k e n n z e i c h n e t, daß das Ätzmittel durch eine Rührvorrichtung bewegt wird.

18. Verfahren nach wenigstens einem der Ansprüche 1 bis 17, d a d u r c h   g e k e n n z e i c h n e t, das das Ätzmittel durch Drehen des Halbleitereinkristalls bewegt wird.

19. Verfahren nach wenigstens einem der Ansprüche 1 bis 18, d a d u r c h   g e k e n n z e i c h n e t, daß das Ätzmittel durch Ultraschall bewegt wird.

20. Verfahren nach wenigstens einem der Ansprüche 1 bis 19, d a d u r c h   g e k e n n z e i c h n e t, daß zur Erhöhung der Ätzrate auf die durchzuätzenden Stellen des Halbleiterkristalls ein mechanischer Druck ausgeübt wird.

21. Verfahren nach wenigstens einem der Ansprüche 1 bis 20, d a d u r c h   g e k e n n z e i c h n e t, daß der mechanische Druck durch Hin- und Herbewegung mindestens eines Metalldrahtes oder Metallblattes ausgeübt wird.

22. Verfahren nach wenigstens einem der Ansprüche 1 bis 21, d a d u r c h   g e k e n n z e i c h n e t, daß das Ätzmittel auf eine geeignete Temperatur erwärmt wird.

23. Halbleiterscheibe, hergestellt nach wenigstens einem der in den Ansprüchen 1 bis 22 beschriebenen Verfahren.

1/1

FIG 1

[111]

(111)

3 2

1

3 2

FIG 2

4

2

1

FIG 3

2

6

6

FIG 4

2

3

<110>

<111>

1

FIG 5

2

4

<110>

(111)

(111)

1

**Europäisches Patentamt**

## EUROPÄISCHER RECHERCHENBERICHT

### EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| D | ANNUAL REVIEW OF MATERIALS SCIENCE, Band 9, September 1979, Palo Alto K.L. KENDALL "Vertical Etching of Silicon at very High Aspect Ratios" Seiten 373 bis 403 * Seite 374, Absatz 6 bis Seite 380 * | 1-5,11, 15 |
| | DE - A - 1 521 978 (SIEMENS) * Ansprüche 1, 2, 6, 9, 11; Seite 5, Zeile 19 bis Seite 7, Zeile 14; Fig. * | 1,4,13, 18, 20-22 |
| | IBM TECHNICAL DISCLOSURE BULLETIN, Band 19, Nr. 10, März 1977 New York E.F. BARAN et al. "Anisotropic Etching Solution with High Etch Rate on Single Crystal Silicon" Seite 3953 | 12 |
| | DE - B - 1 621 483 (LICENTIA PATENT-VERWALTUNGS-GMBH) * Anspruch * | 1,15 |

**KLASSIFIKATION DER ANMELDUNG (Int. Cl.³)**

H 01 L 21/302
C 23 F 1/04

**RECHERCHIERTE SACHGEBIETE (Int. Cl.³)**

B 28 D 5/00
C 23 F 1/00
C 30 B 33/00
H 01 L 21/30

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X | Der vorliegende Recherchenbericht wurde für alle Patentansprüche erstellt.

| Recherchenort | Abschlußdatum der Recherche | Prüfer |
|---|---|---|
| Berlin | 30-10-1981 | GIBBS |

EPA form 1503.1 06.78